Europäisches Patentamt

European Patent Office

Office européen des brevets

(11) EP 0 562 989 B1

(19)

(12) **FASCICULE DE BREVET EUROPEEN**

(45) Date de publication et mention
de la délivrance du brevet:
**16.04.1997 Bulletin 1997/16**

(51) Int Cl.6: **G01R 29/26**, G01R 25/00,
G04F 13/02, G01D 5/28

(21) Numéro de dépôt: **93440028.4**

(22) Date de dépôt: **11.03.1993**

(54) **Procédé et dispositif de mesure du bruit de phase de générateurs d'oscillations sinusoidaux**

Verfahren und Gerät zur Messung des Phasenrauschens eines Sinussignalgenerators

Procedure and apparatus for measuring phase noise of sinusoidal signal generators

(84) Etats contractants désignés:
**AT BE CH DE DK ES FR GB GR IE IT LI LU MC NL PT SE**

(30) Priorité: **12.03.1992 LU 88085**

(43) Date de publication de la demande:
**29.09.1993 Bulletin 1993/39**

(73) Titulaire: **COMMUNAUTE ECONOMIQUE EUROPEENNE (CEE)**
**L-2920 Luxembourg (LU)**

(72) Inventeurs:
• **Miehe, Joseph-Albert**
**67200 Strasbourg (FR)**
• **Cunin, Bernard**
**67200 Strasbourg (FR)**
• **Geist, Paul**
**67300 Schiltigheim (FR)**
• **Grossetie, Jean-Claude**
**21027 Ispra (VA) (IT)**
• **Heisel, Francine**
**67200 Strasbourg (FR)**

• **Martz, Alphonse**
**67840 Kilstett (FR)**

(74) Mandataire: **Nuss, Laurent et al**
**Cabinet Nuss**
**10, rue Jacques Kablé**
**67080 Strasbourg Cedex (FR)**

(56) Documents cités:
GB-A- 2 200 447        US-A- 4 107 701
US-A- 4 412 299        US-A- 4 476 432

• JOURNAL OF PHYSICS E. SCIENTIFIC INSTRUMENTS, vol. 21, no. 7, juillet 1988, pages 701-704, Bristol, GB; G. SHEN et al.: "A versatile optical multichannel analyser system for use with picosecond streak cameras"
• 42ND ANNUAL FREQUENCY CONTROL SYMPOSIUM, Baltimore, MD, 3 juin 1988, pages 432- 441, IEEE, New York, US; F.L. WALLS et al.: "Extending the range and accuracy of phase noise measurements"

## Description

La présente invention concerne les techniques de mesure et de contrôle, plus particulièrement pour des générateurs de très hautes fréquences, et a pour objet un procédé de mesure du bruit de phase de générateurs, notamment d'oscillateurs sinusoïdaux, ainsi qu'un dispositif pour la mise en oeuvre de ce procédé.

L'expression de la tension ou du courant délivré par un oscillateur sinusoïdal est de la forme:

$$V(t) = A_o \sin[\omega_o(t-\Theta(t))]$$

où $A_o$ représente l'amplitude du signal, $\omega_o$ sa fréquence angulaire, t le temps et $\Theta(t)$ une fonction aléatoire qui décrit les fluctuations temporelles du générateur.

Ces dernières induisent des fluctuations de phase caractérisées par la fonction aléatoire $\phi(t)$ telle que:

$$\phi(t) = \omega_o \, \alpha\Theta(t)$$

Si l'oscillateur monochromatique était parfait ($\Theta(t)$ = 0), les instants de passage par zéro seraient répartis périodiquement sur l'axe des temps, avec une période $t_o$ égale à $\pi/\omega_o$.

En pratique, le bruit de phase propre à l'oscillateur induit une fluctuation des instants de passage par zéro qui se distribuent autour des positions correspondant à $kt_o$ (où k est un entier), avec un écart égal à $\Theta(kt_o)$, qui sera noté simplement $\Theta(k)$ dans ce qui suit.

Il existe actuellement déjà différents dispositifs et procédés permettant de mesurer les fluctuations de phase de générateurs de hautes fréquences, mais ce uniquement par la détermination d'une valeur moyenne de ces fluctuations établies grâce à des relevés en grand nombre (par ex. au moyen d'échelles de comptage), ne fournissant aucune indication sur les valeurs instantanées de ces fluctuations.

Le problème posé à la présente invention consiste par conséquent à fournir un procédé et un dispositif permettant la mesure, à un instant donné et pendant un intervalle de temps donné, de la variation de la phase d'un oscillateur électrique sinusoïdal fonctionnant dans le domaine des fréquences élevées ($\simeq$ 100 MHz) et dont la stabilité moyenne à long terme est supérieure à $10^{-9}$. En outre, il devra être possible de déterminer et d'enregistrer d'une part, l'écart instantané $\Theta(k)$ au "coup par coup", c'est-à-dire pour chaque période du signal, et, d'autre part, la distribution d'un nombre n variable de passages successifs par zéro du signal, c'est-à-dire de $\Theta(k)$ à $\Theta(k + n)$, par un mode d'enregistrement répétitif.

Ce problème est précisément résolu, selon l'invention, grâce au procédé de mesure du bruit de phase de générateurs, notamment d'oscillateurs sinusoïdaux, caractérisé en ce qu'il consiste, d'une part, à générer, à partir du signal issu d'un oscillateur à analyser, des trains d'impulsions laser réguliers, pris en compte par une caméra à balayage de fente à très haute résolution temporelle et, d'autre part, à commander simultanément le balayage de ladite caméra au moyen du même signal issu de l'oscillateur à analyser, à relever les traces lumineuses représentatives des impulsions laser reçues sur l'écran de visualisation, soit individuellement, soit par série, au moyen d'une caméra vidéo matricielle, à très haute résolution spatiale, reliée à une unité de traitement et, enfin, à évaluer les décalages, dans la direction de balayage de l'écran de visualisation, des traces lumineuses enregistrées au cours de la mesure par rapport à une trace initiale servant de référence, en vue de déterminer, à un instant donné et pendant un intervalle de temps donné, la variation de la phase du signal dudit oscillateur.

L'invention a également pour objet, un dispositif pour la mise en oeuvre du procédé précité, caractérisé en ce qu'il est constitué, d'une part, par un dispositif de génération de trains d'impulsions laser réguliers, commandé par un oscillateur à analyser, d'autre part, par une caméra à très haute résolution temporelle munie d'un écran de visualisation des traces lumineuses des impulsions laser, individuellement ou par série, dont la caméra à balayage est excitée par le signal de l'oscillateur et, enfin, par une caméra vidéo matricielle, à très haute résolution spatiale, reliée à une unité de traitement, enregistrant et analysant les traces lumineuses apparaissant sur l'écran de visualisation.

L'invention sera mieux comprise grâce à la description ci-après, qui se rapporte à un mode de réalisation préféré, donné à titre d'exemple non limitatif, et expliqué avec référence aux dessins schématiques annexés, dans lesquels:

la figure 1 est un schéma fonctionnel d'un mode de réalisation du dispositif conforme à l'invention;
la figure 2 représente des diagrammes temporels montrant les décalages de phase d'un signal délivré, respectivement, par un oscillateur sinusoïdal idéal et par un oscillateur sinusoïdal réel;
la figure 3 est une vue schématique de l'écran de visualisation portant les traces lumineuses enregistrées par la caméra vidéo au cours d'une séquence de mesure, et,
la figure 4 représente les diagrammes temporels des signaux d'ouverture de la caméra et de décalage des traces lumineuses pour la réalisation de la séquence de mesure représentée à la figure 3.

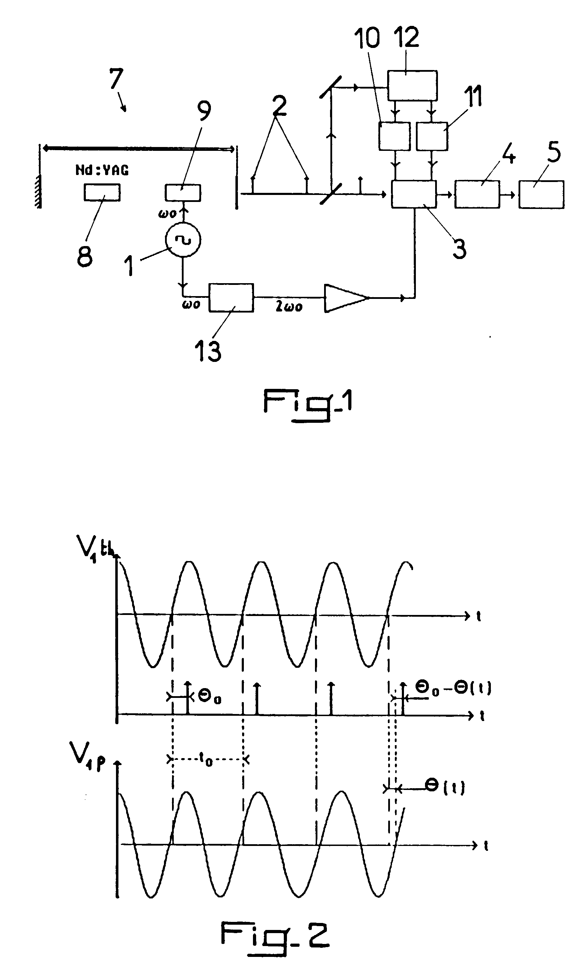

Conformément à l'invention, et comme le montrent les figures 1, 2 et 3 des dessins annexés, le procédé de mesure consiste essentiellement, d'une part, à générer, à partir du signal issu de l'oscillateur 1 à analyser, des trains d'impulsions laser 2 réguliers, pris en compte par une caméra 3 à balayage de fente à très haute résolution temporelle et, d'autre part, à commander simultanément le balayage de ladite caméra 3 au moyen du même signal issu de l'oscillateur 1 à analyser, à relever les traces lumineuses $T_0$, $T_1$, $T_2$, $T_3$, $T_4$ représentatives des impulsions laser 2 reçues sur l'écran de visualisation, soit individuellement, soit par série, au moyen d'une caméra vidéo 4 matricielle, à très haute résolution spatiale, reliée à une unité de traitement 5 et, enfin, à évaluer les décalages, dans la direction de balayage de l'écran de visualisation, des traces lumineuses $T_1$, $T_2$, $T_3$, $T_4$ enregistrées au cours de la mesure par rapport à une trace initiale $T_0$ servant de référence, en vue de déterminer, à un instant donné et pendant un intervalle de temps donné, la variation de la phase du signal dudit oscillateur 1.

Les séquences d'ouverture, de durées réglables, de la caméra 3 à très haute résolution sont avantageusement commandées au moyen de signaux adéquats, synchronisés par rapport aux trains d'impulsions laser 2.

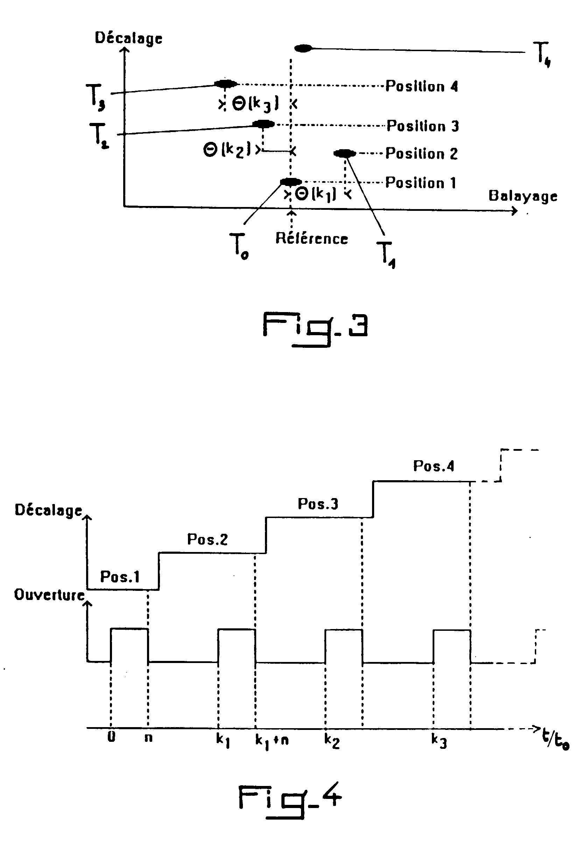

Selon un premier mode de mise en oeuvre de l'invention, le procédé consiste également, pour chaque nouvelle ouverture de la caméra 3 à très haute résolution, à décaler, sur l'écran de visualisation, la trace lumineuse $T_1$, $T_2$, $T_3$ ou $T_4$ représentative de la ou des impulsions laser 2 incidentes par rapport à la trace lumineuse $T_0$, $T_1$, $T_2$ ou $T_3$ précédente, dans une direction perpendiculaire à celle du balayage de l'écran de visualisation, ce grâce à un signal adéquat synchronisé par rapport aux trains d'impulsions laser 2 (Figures 3 et 4).

Conformément à un second mode de mise en oeuvre de l'invention, non représenté aux dessins annexés, les traces lumineuses $T_1$, $T_2$, $T_3$, $T_4$ représentatives d'impulsions laser 2 ou de séries d'impulsions laser 2 consécutives, sont décalées, de manière continue et en fonction de leur apparition, dans une direction perpendiculaire à celle du balayage de l'écran de visualisation, ce grâce à un signal adéquat synchronisé par rapport aux trains d'impulsions laser 2.

Comme le montre la figure 1 des dessins annexés, les trains d'impulsions laser 2 peuvent être générés par un laser 7, par exemple du type Nd-YAG, comportant un modulateur acousto-optique 9, excité par le signal issu de l'oscillateur 1 à analyser, et, éventuellement, associé à un dispositif compresseur d'impulsions.

Selon un mode de réalisation préférentiel, non représenté aux dessins annexés, les trains d'impulsions laser sont générés par un laser à couplage actif des modes, relié par un dispositif de synchronisation sans fluctuation temporelle à un laser de base, dont le blocage des modes longitudinaux est réalisé par le signal issu de l'oscillateur à analyser.

L'invention a également pour objet un dispositif pour la mise en oeuvre du procédé décrit ci-dessus, représenté à la figure 1 des dessins annexés, principalement constitué, d'une part, par un dispositif 7 de génération de trains d'impulsions laser 2 réguliers, commandé par l'oscillateur 1 à analyser, d'autre part, par une caméra 3 à balayage de fente à très haute résolution temporelle munie d'un écran de visualisation des traces

lumineuses $T_0$, $T_1$, $T_2$, $T_3$, $T_4$ des impulsions laser 2, individuellement ou par série, dont le dispositif de balayage est excité par le signal de l'oscillateur 1 et, enfin, par une caméra vidéo 4 matricielle, à très haute résolution spatiale, reliée à une unité de traitement 5, enregistrant et analysant les traces lumineuses $T_o$, $T_1$, $T_2$, $T_3$, $T_4$ apparaissant sur l'écran de visualisation.

Conformément à une caractéristique de l'invention, la caméra 3 à balayage de fente à très haute résolution temporelle est pourvue d'un obturateur électronique ultra-rapide commandé par un générateur 10 de signaux en créneaux de durées réglables, synchronisé par rapport aux trains d'impulsions laser 2.

En outre, la caméra 3 à balayage à fente à très haute résolution temporelle est avantageusement munie d'un dispositif de décalage des traces lumineuses $T_1$, $T_2$, $T_3$, $T_4$ sur son écran de visualisation, dans une direction perpendiculaire à celle du balayage de ce dernier, commandé par un générateur 11 de signaux en forme d'escaliers ou de rampes.

Selon un premier mode de réalisation de l'invention, représenté à la figure 1 des dessins annexés, le dispositif 7 de génération d'impulsions laser se présente sous la forme d'un cristal laser 8, par exemple du type Nd-YAG, dont les modes longitudinaux sont verrouillés en phase par un modulateur acousto-optique 9 excité par le signal délivré par l'oscillateur 1 à analyser, ledit laser 7 pouvant, le cas échéant, être associé à un dispositif compresseur d'impulsions.

Conformément à un mode de réalisation préférentiel de l'invention, non représenté aux dessins annexés, le dispositif 7 de génération d'impulsions laser consiste en un laser à couplage actif des modes pourvu d'un modulateur acousto-optique commandé, par l'intermédiaire d'un dispositif de synchronisation sans fluctuation de phase, par un laser de base, dont le modulateur acousto-optique est excité par le signal délivré par l'oscillateur à analyser.

Dans la description qui suit, l'invention sera décrite de manière plus détaillée en se référant à l'exemple de réalisation illustré par les dessins annexés.

Comme le montre la figure 1 des dessins annexés, le dispositif 7 de génération d'impulsions laser 2 comporte un cristal laser 8 pompé optiquement, dont la cavité comporte un cristal acousto-optique 9 qui est excité par le signal sinusoïdal V(t) délivré par l'oscillateur 1. Il en résulte des pertes de diffraction proportionnelles au carré de V(t): le gain du laser est donc une fonction périodique de fréquence fondamentale angulaire $2\omega_o$.

Lorsque la longueur de la cavité est telle que le temps mis par un photon pour effectuer un aller-retour est égal à $t_o$ ($=\pi/\omega_o$), les modes longitudinaux du laser sont verrouillés en phase et celui-ci émet des impulsions de durée brève, qui se répètent avec une période moyenne égale à $t_o$ et un écart type de l'ordre de 5 ps. Il est possible, par exemple, d'utiliser le laser 7 seul, ou de l'associer à un compresseur d'impulsions, ou, encore, à un laser à colorant pour lequel il joue le rôle de source de pompage synchrone, comme indiqué précédemment.

Dans le premier cas, la durée des impulsions obtenues à la sortie d'un cristal, doubleur de fréquence, non représenté sur la figure 1 des dessins annexés, est de l'ordre de 50 ps, dans les deux autres cas, elle est inférieure à 10 ps.

Ce signal lumineux, très peu affecté par les fluctuations de phase de l'oscillateur 1 constitue la référence temporelle pour le procédé et le dispositif de mesure selon l'invention.

Il est visualisé sur l'écran d'une caméra 3 dont la résolution est de l'ordre de la picoseconde et qui fonctionne en mode dit "synchroscan", sa photocathode étant illuminée ponctuellement.

Les plaques de déflexion principales de cette caméra 3, assurant le balayage, sont excitées en permanence par un signal $V_1(t)$ délivré par un circuit 13 et proportionnel au carré de celui $V(t)$ délivré par l'oscillateur 1, présentant la forme suivante:

$$V_1(t) = A_1 \sin[2\omega_o(t-\Theta(t))]$$

Si le bruit de phase du générateur 1 était négligeable, le retard $\Theta_o$ entre chaque impulsion laser 2 émise et les instants de passage par zéro du signal $V_1(t)$ serait constant (courbe $V_1$th sur figure 2) et, dans ces conditions, chaque impact ou trace lumineuse $T_1$, $T_2$, $T_3$, $T_4$ sur l'écran de visualisation devrait se superposer exactement aux précédentes.

En pratique, le bruit de phase du signal de déflexion ou le balayage entraîne une variation des instants de passage par zéro qui sont décalés de $\Theta(t)$ par rapport au cas précédent (courbe $V_1$p sur figure 2).

Les impulsions laser n'étant pratiquement pas affectées par ce bruit, elles présentent un retard apparent $R(t)$ égal à:

$$R(t) = \Theta_o - \Theta(t)$$

Il en résulte une variation de la position de la trace lumineuse associée à chaque impulsion laser 2.

Ces traces lumineuses sont relevées par une caméra vidéo 4 matricielle numérique, par exemple de type CCD, qui, en association avec un ordinateur ou autre unité de traitement 5 permet de reconstituer numériquement le profil temporel correspondant et de déterminer la position du barycentre de chaque impulsion laser 2 résolue spatialement avec une précision de l'ordre de quelques picosecondes, permettant ainsi une détermination directe de la fonction aléatoire $\Theta(k)$.

La caméra 3 est avantageusement munie d'un obturateur électronique ultra-rapide contrôlé par un générateur 10 qui permet d'ajuster la durée d'ouverture de manière continue, à partir d'une valeur minimale de 10 ns. Elle est également équipée d'un dispositif de décalage dans un sens perpendiculaire à celui du balayage mentionné ci-dessus. Le générateur de commande 11 correspondant délivre soit une tension en "marches d'escalier" qui comporte quatre paliers de niveaux différents et de durée réglable (> 100 ns), soit une tension de décalage qui varie linéairement avec le temps et dont la durée est ajustable entre 1µs et 20 ms.

Le fonctionnement de ces deux générateurs 10 et 11 est synchronisé par rapport au train d'impulsions laser 2 par un circuit de contrôle 12.

Le déroulement d'une mesure est illustré, pour un mode de mise en oeuvre de l'invention, par les figures 4 et 3 qui représentent les chronogrammes des signaux délivrés par les générateurs d'obturateur 10, de décalage 11 et une vue schématique de l'écran de la caméra 3.

La tension de décalage étant initialement nulle, le générateur 10 fournit un signal qui fait passer l'obturateur de la caméra 3 de l'état fermé (représenté symboliquement pas un niveau bas de la commande) à l'état ouvert (niveau haut) pendant une durée réglable $nt_o$ : on enregistre alors sur l'écran de visualisation de la caméra 3 la superposition de n impulsions laser 2 successives.

Pour une valeur de n modérée (n≈10), la phase instantanée $\phi(t)$ du signal de balayage, issu du signal délivré par l'oscillateur 1, peut être considérée comme constante pendant l'intervalle de temps $nt_o$ ($\simeq$ 100ns) : les impulsions lumineuses se superposent donc de façon quasi-parfaite pour donner une trace lumineuse $T_o$, qui sert de référence temporelle.

Après cette acquisition, le générateur 1 fait passer la tension de décadrage ou de décalage à une valeur supérieure.

L'obturateur est alors à nouveau ouvert à l'instant $k_1 t_o$, pendant une nouvelle durée $nt_o$ : en comparant la position de la nouvelle trace $T_1$ lumineuse à la position de la trace de référence $T_o$ précédente, il est possible de mesurer directement la variation de phase $\Theta(k_1)$.

Les opérations ci-dessus sont répétées, dans la cadre de l'exemple illustré à la figure 3, pour les trois paliers de tensions de décadrage suivants qui sont associées aux traces lumineuses $T_2$, $T_3$, $T_4$ et aux grandeurs $\Theta(k_2)$ $\Theta(k_3)$, et $\Theta(k_4)$.

En complément de ce qui précède, il est à noter, en ce qui concerne notamment la figure 4 des dessins annexés, que les cas n = 1 et n > 1 correspondent, respectivement, aux modes d'enregistrement au "coup par coup" et répétitif, mentionnés plus haut.

Par ailleurs, le principe de la mesure demeure inchangé pour une tension de décalage en forme de rampe, la variation continue de la variable aléatoire $\Theta(k)$ étant alors enregistrée.

## Revendications

1. Procédé de mesure du bruit de phase de générateurs, notamment d'oscillateurs sinusoïdaux, caractérisé en ce qu'il consiste, d'une part, à générer, à partir du signal issu d'un oscillateur (1) à analyser, des trains d'impulsions laser (2) réguliers, pris en compte par une caméra à balayage de fente (3) à très haute résolution temporelle et, d'autre part, à commander simultanément le balayage de ladite caméra (3) au moyen du même signal issu de l'oscillateur (1) à analyser, à relever les traces lumineuses ($T_0$, $T_1$, $T_2$, $T_3$, $T_4$) représentatives des impulsions laser (2) reçues sur l'écran de visualisation, soit individuellement, soit par série, au moyen d'une caméra vidéo (4) matricielle, à très haute résolution spatiale, reliée à une unité de traitement (5) et, enfin, à évaluer les décalages, dans la direction de balayage de l'écran de visualisation, des traces lumineuses ($T_1$, $T_2$, $T_3$, $T_4$) enregistrées au cours de la mesure par rapport à une trace initiale ($T_0$) servant de référence, en vue de déterminer, à un instant donné et pendant un intervalle de temps donné, la variation de la phase du signal dudit oscillateur (1).

2. Procédé de mesure selon la revendication 1, caractérisé en ce qu'il consiste à commander les séquences d'ouverture, de durées réglables, de la caméra (3) à très haute résolution temporelle au moyen de signaux adéquats, synchronisés par rapport aux trains d'impulsions laser (2).

3. Procédé de mesure selon la revendication 2, caractérisé en ce qu'il consiste, pour chaque nouvelle ouverture de la caméra (3) à très haute résolution temporelle, à décaler, sur l'écran de visualisation, la trace lumineuse ($T_1$, $T_2$, $T_3$ ou $T_4$) représentative de la ou des impulsions laser (2) incidentes par rapport à la trace lumineuse ($T_0$, $T_1$, $T_2$ ou $T_3$) précédente, dans une direction perpendiculaire à celle du balayage de l'écran de visualisation, ce grâce à un signal adéquat synchronisé par rapport aux trains d'impulsions laser (2).

4. Procédé de mesure selon l'une quelconque des revendications 1 et 2, caractérisé en ce qu'il consiste à décaler les traces lumineuses ($T_1$, $T_2$, $T_3$, $T_4$), représentatives d'impulsions laser (2) ou de séries d'impulsions lasers (2) consécutives de manière continue et en fonction de leur apparition, dans une direction perpendiculaire à celle du balayage de l'écran de visualisation, ce grâce à un signal adéquat synchronisé par rapport aux trains d'impulsions laser (2).

5. Procédé de mesure selon l'une quelconque des revendications 1 à 4, caractérisé en ce que les trains d'impulsions laser (2) sont générés par un laser (7), par exemple de type Nd-YAG, comportant un modulateur acousto-optique (9), excité par le signal issu de l'oscillateur (1) à analyser, et, éventuellement, associé à un dispositif compresseur d'impulsions.

6. Procédé de mesure selon l'une quelconque des revendications 1 à 4, caractérisé en ce que les trains d'impulsions laser sont générés par un laser à couplage actif des modes, relié par un dispositif de synchronisation sans fluctuation temporelle à un laser de base, dont le blocage des modes longitudinaux est réalisé par le signal issu de l'oscillateur à analyser.

7. Dispositif de mesure du bruit de phase de générateurs, pour la mise en oeuvre du procédé de mesure selon l'une quelconque des revendications 1 à 6, caractérisé en ce qu'il est constitué, d'une part, par un dispositif (7) de génération de trains d'impulsions laser (2) réguliers, commandé par un oscillateur (1) à analyser, d'autre part, par une caméra à balayage de fente (3) à très haute résolution temporelle munie d'un écran de visualisation des traces lumineuses ($T_0$, $T_1$, $T_2$, $T_3$, $T_4$) des impulsions laser (2), individuellement ou par série, dont la caméra à balayage est excitée par le signal de l'oscillateur (1) et, enfin, par une caméra vidéo (4) matricielle, à très haute résolution spatiale, reliée à une unité de traitement (5), enregistrant et analysant les traces lumineuses ($T_0$, $T_1$, $T_2$, $T_3$, $T_4$) apparaissant sur l'écran de visualisation.

8. Dispositif selon la revendication 7, caractérisé en ce que la caméra à balayage de fente (3) à très haute résolution temporelle est pourvue d'un obturateur électronique ultra-rapide commandé par un générateur (10) de signaux en créneaux de durées réglables, synchronisé par rapport aux trains d'impulsions laser (2).

9. Dispositif selon l'une quelconque des revendications 7 et 8, caractérisé en ce que la caméra à balayage de fente (3) à très haute résolution temporelle est munie d'un dispositif de décalage des traces lumineuses ($T_1$, $T_2$, $T_3$, $T_4$) sur son écran de visualisation, dans une direction perpendiculaire à celle du balayage de ce dernier, commandé par un générateur (11) de signaux en forme d'escaliers ou de rampes.

10. Dispositif selon l'une quelconque des revendications 7 à 9, caractérisé en ce que le dispositif (7) de génération d'impulsions laser se présente sous la forme d'un cristal laser (8), préférentiellement du type Nd-YAG, dont les modes longitudinaux sont verrouillés en phase par un modulateur acousto-optique (9) excité par le signal délivré par l'oscillateur (1) à analyser, ledit laser (7) pouvant, le cas échéant, être associé à un dispositif compresseur d'impulsions.

**11.** Dispositif selon l'une quelconque des revendications 7 à 9, caractérisé en ce que le dispositif (7) de génération d'impulsions laser consiste en un laser à couplage actif des modes pourvu d'un modulateur acousto-optique commandé, par l'intermédiaire d'un dispositif de synchronisation sans fluctuation de phase, par un laser de base, dont le modulateur acousto-optique est excité par le signal délivré par l'oscillateur à analyser.

**12.** Dispositif selon l'une quelconque des revendications 7 à 11, caractérisé en ce que la résolution temporelle des caméras est de l'ordre de la picoseconde.

**Patentansprüche**

**1.** Verfahren zur Messung des Phasenzitterns von Generatoren, insbesondere Sinusoszillatoren, **dadurch gekennzeichnet**, daß es darin besteht, einerseits auf der Grundlage von einem Signal, das von einem zu analysierenden Oszillator (1) ausgeht, gleichmäßige Laserimpulszüge (2) zu erzeugen, die von einer Kamera (3) zur Verarbeitung aufgenommen werden, die eine Zeitschlitzabtastung mit sehr hoher Auflösung vornimmt, und andererseits darin besteht, gleichzeitig die Abtastung dieser Kamera (3) mittels des gleichen, vom zu analysierenden oszillator abgegebenen Signals zu steuern, ferner darin besteht, Leuchtspuren ($T_0$, $T_1$, $T_2$, $T_3$, $T_4$) zu erzeugen, die die Laserimpulse (2) repräsentieren und entweder einzeln oder als Reihe mittels einer Matrix-Videokamera (4) mit sehr hoher räumlicher Auflösung auf dem Sichtschirm festgehalten werden, wobei diese Videokamera mit einer Verarbeitungseinheit (5) verbunden ist, und schließlich darin besteht, die Verschiebungen der Leuchtspuren ($T_1$, $T_2$, $T_3$, $T_4$) in Richtung der Sichtschirmabtastung auszuwerten, wobei diese Leuchtspuren inbezug auf eine als Bezug dienende Anfangsspur ($T_0$) gespeichert werden, um von einem gegebenen Zeitpunkt an und während eines vorgegebenen Zeitintervalls die Änderung der Signalphase des Oszillators (1) zu bestimmen.

**2.** Meßverfahren nach Anspruch 1, dadurch gekennzeichnet, daß es darin besteht, die eine einstellbare Dauer aufweisenden Öffnungssequenzen der eine sehr hohe Auflösung aufweisenden Kamera (3) mittels entsprechender Signale zu steuern, die inbezug auf die Laserimpulszüge (2) synchronisiert sind.

**3.** Meßverfahren nach Anspruch 2, dadurch gekennzeichnet, daß es darin besteht, für jede neue Öffnung der mit hoher Auflösung arbeitenden Kamera (3) auf dem Sichtschirm die Leuchtspur ($T_1$, $T_2$, $T_3$ oder $T_4$), die repräsentativ für den oder die Laserimpulse (2) ist, die gemäß der vorhergehenden Leuchtspur ($T_0$, $T_1$, $T_2$ oder $T_3$) auftreten, in einer Richtung zu verschieben, die senkrecht zu der der Sichtschirmabtastung liegt, und zwar aufgrund eines Signals, das inbezug auf die Laserimpulszüge (2) emtsprechend synchronisiert ist.

**4.** Meßverfahren nach Anspruch 1 oder 2, dadurch gekennzeichnet, daß es darin besteht, die für die Laserimpulse (2) oder aufeinanderfolgender Laserimpulsreihen (2) repräsentativen Leuchtspuren ($T_1$, $T_2$, $T_3$, $T_4$) fortwährend und abhängig von ihrem Auftreten in einer Richtung zu verschieben, die senkrecht zu der der Sichtschirmabtastung liegt, und zwar aufgrund eines Signals, das inbezug auf die Laserimpulszüge (2) entsprechend synchronisiert ist.

**5.** Meßverfahren nach einem der Ansprüche 1 bis 4, dadurch gekennzeichnet, daß die Laserimpulszüge vom einem Laser (7), beispielsweise vom Typ Nd-YAG, erzeugt werden, der aus einem akustooptischen Modulator (9) besteht, durch das Signal, das vom zu analysierenden Oszillator ausgeht, angeregt wird und dem gegebenenfalls eine Impulskompressorschaltung zugeordnet ist.

**6.** Meßverfahren nach einem der Ansprüche 1 bis 4, dadurch gekennzeichnet, daß die Laserimpulszüge vom einem Laser zur aktiven Modenkopplung erzeugt werden, der über eine keine Zeitschwankungen aufweisende Synchronisationsschaltung mit einem Basislaser verbunden ist, wobei die Sperrung der Längsschwingungen dieses Basislasers durch das Signal erfolgt, das vom zu analysierenden Oszillator ausgeht.

**7.** Schaltungsanordnung zur Messung des Phasenzitterns von Generatoren zur Durchführung des Meßverfahrens nach einem der Ansprüche 1 bis 6, dadurch gekennzeichnet, daß sie einerseits eine Schaltung (7) zur Erzeugung von gleichmäßigen Laserimpulszügen (2), die durch den zu analysierenden Oszillator (1) gesteuert wird, und andererseits eine Kamera (3) zur Zeitschlitzabtastung mit sehr hoher zeitlicher Auflösung, die mit einem Schirm zur Sichtbarmachung von Leuchtspuren ($T_0$, $T_1$, $T_2$, $T_3$, $T_4$) der einzelnen oder in Reihen vorliegenden Laserimpulse (2) versehen ist, wobei die Abtastschaltung durch das Signal des Oszillators (1) gesteuert wird, und schließlich eine Matrix-Videokamera (4) mit sehr hoher räumlicher Auflösung aufweist, die mit einer Verarbeitungseinheit (5) verbunden ist, die die auf dem Sichtschirm erscheinenden Leuchtspuren ($T_0$, $T_1$, $T_2$, $T_3$, $T_4$) speichert und analysiert.

8. Schaltungsanordnung nach Anspruch 7, dadurch gekennzeichnet, daß die zur Zeizschlitzabtastung mit zeitlich sehr hoher Auflösung vorgesehene Kamera (3) mit einem ultraschnellen, elektronischen Verschluß versehen ist, der von einem Generator (10) zur Erzeugung von Rechteckimpulsen einstellbarer Dauer gesteuert wird, die inbezug auf die Laserimpulszüge (2) synchronisiert sind.

9. Schaltungsanordnung nach Anspruch 7 oder 8, dadurch gekennzeichnet, daß die zur Zeitschlitzabtastung mit zeitlich sehr hoher Auflösung vorgesehene Kamera (3) mit einer Schaltung zur Verschiebung der auf dem Sichtschirm erscheinenden Leuchtspuren ($T_1$, $T_2$, $T_3$, $T_4$) in einer Richtung, die senkrecht zu der der vorhergehenden Abtastung liegt, versehen ist, wobei diese Schaltung durch einen Generator (11) zur Erzeugung von Signalen gesteuert wird, die die Form von Treppen oder Rampen haben.

10. Schaltungsanordnung nach einem der Ansprüche 7 bis 9, dadurch gekennzeichnet, daß die zur Erzeugung der Laserimpulse vorgesehene Schaltung (7) als Kristallaser 8, vorzugsweise vom Typ Nd-YAG, ausgebildet ist, dessen Längsschwingungen durch einen akustooptischen Modulator (9) phasenverriegelt sind, der durch dasjenige Signal gesteuert wird, das von dem zu analysierenden Oszillator (1) abgegeben wird, wobei die Laserschaltung (7) gegebenenfalls mit einer Impulskompressorschaltung versehen ist.

11. Schaltungsanordnung nach einem der Ansprüche 7 bis 9, dadurch gekennzeichnet, daß die zur Erzeugung der Laserimpulse vorgesehene Schaltung (7) als Laser mit aktiver Modenkopplung ausgebildet ist, der mit einem akustooptischem Modulator versehen ist, der mittels einer keine Phasenschwankungen aufweisenden Synchronisationsschaltung und durch einen Basislaser gesteuert wird, wobei der akustooptische Laser durch dasjenige Signal gesteuert wird, das vom zu analysierenden Oszillator abgegeben wird.

12. Schaltungsanordnung nach einem der Ansprüche 7 bis 11, dadurch gekennzeichnet, daß die zeitliche Auflösung der Kameras in der Größenordnung von Picosekunden liegt.

## Claims

1. Process for measuring the phase noise of generators, in particular sinusoidal oscillators, characterised in that it involves, on the one hand, generating, from the signal issuing from an oscillator (1) to be analysed, regular laser pulse trains (2) detected by a slot scanning camera (3) having very high time resolution and, on the other hand, simultaneously controlling the scanning of said camera (3) by means of the same signal issuing from the oscillator (1) to be analysed, reading the light traces ($T_0$, $T_1$, $T_2$, $T_3$, $T_4$) representative of the laser pulses (2) received on the display screen either individually or in series by means of a matrix video camera (4) having very high spatial resolution connected to a processing unit (5) and finally evaluating the shifts in the scanning direction of the display screen of the light traces ($T_1$, $T_2$, $T_3$, $T_4$) recorded during measurement relative to an initial trace ($T_0$) serving as a reference in order to determine the variation in the phase of the signal from said oscillator (1) at a given moment and for a given time interval.

2. Measuring process according to claim 1, characterised in that it involves controlling the opening sequences, of adjustable durations, of the camera (3) having very high time resolution by means of suitable signals synchronised relative to the laser pulse trains (2).

3. Measuring process according to claim 2, characterised in that it involves, for each re-opening of the camera (3) having very high time resolution, shifting on the display screen the light trace ($T_1$, $T_2$, $T_3$, or $T_4$) representative of the incident laser pulse or pulses (2) relative to the preceding light trace ($T_0$, $T_1$, $T_2$ or $T_3$), in a direction perpendicular to the direction of scanning of the display screen by means of a suitable signal which is synchronised relative to the laser pulse trains (2).

4. Measuring process according to any one of claims 1 and 2, characterised in that it involves shifting the light traces ($T_1$, $T_2$, $T_3$, $T_4$) representative of consecutive laser pulses (2) or series of laser pulses (2) continuously and as they appear, in a direction perpendicular to the scanning direction of the display screen by means of a suitable signal synchronised relative to the laser pulse trains (2).

5. Measuring process according to any one of claims 1 to 4, characterised in that the laser pulse trains (2) are generated by a laser (7), for example of the Nd-YAG type, comprising an acousto-optical modulator (9) excited by the signal issuing from the oscillator (1) to be analysed and optionally associated with a pulse compressing device.

6. Measuring process according to any one of claims 1 to 4, characterised in that the laser pulse trains are generated by a laser for active coupling of the modes connected by a synchronising device without time fluctuation to a basic laser of which the longitudinal modes are blocked by the signal issuing from the oscillator to be analysed.

7. Device for measuring the phase noise of generators for carrying out the measuring process according to any one of claims 1 to 6, characterised in that it consists, on the one hand, of a device (7) for generating regular laser pulse trains (2) controlled by an oscillator (1) to be analysed, on the other hand of a slot scanning camera (3) having very high time resolution equipped with a screen for displaying the light traces ($T_0$, $T_1$, $T_2$, $T_3$, $T_4$) of the laser pulses (2), individually or in series, of which the scanning camera is excited by the signal from the oscillator (1) and, finally, of a matrix video camera (4) having very high spatial resolution and connected to a processing unit (5) recording and analysing the light traces ($T_0$, $T_1$, $T_2$, $T_3$, $T_4$) appearing on the display screen.

8. Device according to claim 7, characterised in that the slot scanning camera (3) having very high time resolution is provided with an ultra-rapid electronic blocking device controlled by a generator (10) of strobe pulse signals of adjustable durations, synchronised relative to the laser pulse trains (2).

9. Device according to any one of claims 7 and 8, characterised in that the slot scanning camera (3) having very high time resolution is equipped with a device for shifting the luminous traces ($T_1$, $T_2$, $T_3$, $T_4$) on its display screen in a direction perpendicular to the scanning direction thereof, controlled by a generator (11) of step-shaped or ramp-shaped signals.

10. Device according to any one of claims 7 to 9, characterised in that the device (7) for generating laser pulses has the form of a laser crystal (8), preferably of the Nd-YAG type, of which the longitudinal modes are phase locked by an acousto-optical modulator (9) excited by the signal delivered by the oscillator (1) to be analysed, said laser (7) optionally being able to be associated with a pulse compressing device.

11. Device according to any one of claims 7 to 9, characterised in that the laser pulse generating device (7) consists of a laser for active coupling of the modes provided with an acousto-optical modulator controlled, by means of a synchronising device without phase fluctuation, by a basic laser of which the acousto-optical modulator is excited by the signal delivered by the oscillator to be analysed.

12. Device according to any one of claims 7 to 11, characterised in that the time resolution of the cameras is of the order of a picosecond.

Fig-1

Fig-2

Fig. 3

Fig. 4